(19) **Europäisches Patentamt European Patent Office Office européen des brevets**

(11) **EP 4 648 109 A1**

(12) **EUROPEAN PATENT APPLICATION**

(43) Date of publication:
**12.11.2025 Bulletin 2025/46**

(21) Application number: **25175529.4**

(22) Date of filing: **09.05.2025**

(51) International Patent Classification (IPC):
*H01L 25/075* (2006.01)   *H10H 20/01* (2025.01)
*H10H 20/85* (2025.01)   *H10H 20/855* (2025.01)
*H10H 29/14* (2025.01)

(52) Cooperative Patent Classification (CPC):
**H10H 20/011; H01L 25/0753; H10H 20/0363;**
**H10H 20/8504; H10H 20/855; H10H 29/142;**
H10H 20/017; H10H 20/019; H10H 20/819;
H10H 20/82

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **10.05.2024 US 202418661153**

(71) Applicant: **Microsoft Technology Licensing LLC**
**Redmond, WA 98052-6399 (US)**

(72) Inventors:
• **GOMEZ DIAZ, Ariel**
  **Redmond 98052-6399 (US)**
• **LIU, Junyi**
  **Redmond 98052-6399 (US)**
• **SHI, Kai**
  **Redmond 98052-6399 (US)**

• **SIEW, Shawn Yohanes**
  **Redmond 98052-6399 (US)**
• **ROBERTSON, Brian**
  **Redmond 98052-6399 (US)**
• **CLETHEROE, Daniel Jonathan Finchley**
  **Redmond 98052-6399 (US)**
• **COSTA, Paolo**
  **Redmond 98052-6399 (US)**
• **LYUTSAREY, Vasily**
  **Redmond 98052-6399 (US)**
• **YANG, Mengyang**
  **Redmond 98052-6399 (US)**
• **BENYAHYA, Kaoutar**
  **Redmond 98052-6399 (US)**

(74) Representative: **Page White Farrer**
**Bedford House**
**21a John Street**
**London WC1N 2BF (GB)**

(54) **MICRO-LEDS FOR OPTICAL COMMUNICATION SYSTEMS**

(57) A method of manufacturing a light-emitting diode device comprises fabricating a light-emitting diode structure comprising an inorganic semiconductor; and fabricating an optic over the light-emitting diode structure using nano-imprint lithography. The method may further comprise, before fabricating the optic, forming a first lens on the light-emitting diode structure by thermal reflow lithography. The optic and first lens may improve the efficiency of the light-emitting diode device by reducing losses due to total internal reflection. Also provided are light emitting diode devices obtainable by the method.

Fig. 5D

EP 4 648 109 A1

**Description**

<u>Background</u>

Fibre-optic communications involve encoding data as pulses of light, which are transmitted through optical fibres from a transmitter to a receiver. Fibre-optic communication systems are used in a variety of contexts to transfer information, such as for telephone and internet communication, as well as for broadcasting television signals. Fibre optic communication systems are also widely used for intra-datacentre connectivity, where emerging workloads such as machine learning and resource disaggregation are significantly increasing network demands.

Micro-sized light-emitting diodes (microLEDs; μLEDs) have been proposed as light sources for optical communications. There is a demand for densely-packed arrays of μLEDs, in order to allow for a larger numbers of communication channels per unit area.

Density is constrained by optical interference and cross-talk. Cross-talk is where a signal which is intended for one communication channel is received via a different communication channel. It would be desirable to provide a μLED with increased density and reduced cross-talk.

<u>Summary</u>

In one aspect, there is provided a method of manufacturing a light-emitting diode device. The method comprises fabricating a light-emitting diode structure comprising an inorganic semiconductor; and fabricating an optic over the light-emitting diode structure using nano-imprint lithography.

A related aspect provides a light-emitting diode device obtainable by the method, comprising a light-emitting structure comprising an inorganic semiconductor; and a nano-imprinted optic arranged over the light-emitting structure.

The nano-imprinted optic may improve the efficiency with which light can be extracted from the light-emitting structure, by reducing losses caused by total internal reflection.

An embodiment provides an array comprising a plurality of such light-emitting diode devices, arranged on a backplane. In such an embodiment, the nano-imprinted optic may reduce optical interference between nearby LEDs by focussing and/or collimating the emitted light.

Another embodiment provides a system comprising the array and an optical relay arranged over the array. The optical relay comprises a first lens, a turning prism arranged downstream of the first lens or an optical path, and a second lens arranged downstream of the turning prism on the optical path.

A further aspect provides a method of fabricating a light emitting diode device. The method includes epitaxially growing a layer of a first semiconductor over a substrate; and epitaxially growing a layer of a second semiconductor over the layer of the first semiconductor. Subsequently, the method includes selectively etching the layers to form a mesa; and selectively etching the mesa to remove a portion of the second semiconductor along one edge of the mesa, to form a stepped mesa having an exposed portion of the first semiconductor. After forming the stepped mesa, the method further comprises forming a first electrical contact on the exposed portion of the first semiconductor, and forming a second electrical contact on the second semiconductor. One of the first and second semiconductors is a p-type semiconductor, and one of the first and second semiconductors is an n-type semiconductor.

The method may avoid formation of side-wall bumps which are found in LEDs manufactured by conventional processes. Eliminating the side-wall bump reduces the physical size of the LED and may reduce light emission from the sides of the LED.

A related aspect provides a light-emitting diode device obtainable by the method. The light-emitting diode device comprises: a first layer comprising a first inorganic semiconductor; and a second layer comprising a second inorganic semiconductor, the second layer being arranged over the first layer. Exactly one edge of the first layer extends beyond an edge of the second layer, thereby defining an exposed portion of the first layer. The light-emitting diode device further comprises a first electrical contact arranged on the exposed portion of the first layer, and a second electrical contact arranged on a top surface of the second layer. One of the first and second inorganic semiconductors is a p-type semiconductor and one of the first and second inorganic semiconductors is an n-type semiconductor.

Still another aspect provides a light-emitting diode device, comprising a light-emitting structure comprising an inorganic semiconductor; and a lens obtainable by thermal reflow lithography arranged over the light-emitting structure. Thermal reflow lithography may allow a lens to be fabricated from materials with high refractive indices. This may reduce losses due to internal reflection.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter. Nor is the claimed subject matter limited to implementations that solve any or all of the disadvantages noted herein.

<u>Brief Description of the Drawings</u>

To assist understanding of embodiments of the present disclosure and to show how such embodiments may be put into effect, reference is made, by way of example only, to the accompanying drawings in which:

Fig. 1 is a schematic cross-section of a light-emitting diode device in accordance with a comparative example;

Fig. 2 is a flow diagram outlining an example method of fabricating a light-emitting diode device;

Figs. 3A to 3D are schematic cross-sections of workpieces obtained at various stages of the method of Fig. 2;

Fig. 4 is a flow diagram outlining the example method of forming an optic over a light-emitting diode;

Figs. 5A to 5D are schematic cross-sections of workpieces obtained at various stages of the method of Fig. 4;

Fig. 6 is a schematic cross-section of a circular parabolic concentrator;

Fig. 7 is a schematic cross-section of a total internal reflection lens;

Fig. 8 is a schematic plan view of an example μLED array;

Fig. 9 is a schematic diagram of an optical relay useful with the μLED array; and

Fig. 10 is a block diagram of an optical communication system.

<u>Detailed Description</u>

A μLED is a light-emitting diode including a semiconductor structure with a critical dimension of less than or equal to 100 μm, and typically less than or equal to 50 μm. The critical dimension is defined herein as the diameter of the smallest circle which will completely enclose the μLED when viewed in plan view.

The minimum size of the μLED is not particularly limited, and may vary depending upon the precision of the fabrication methods chosen. For example, the μLED may have a critical dimension of at least 1 μm, optionally at least 10 μm.

All refractive indices reported herein are measured relative to vacuum, using light at a wavelength of 546.07 nm.

Directional terms such as "top", "bottom", "left", "right", "above", "below", "horizontal" and "vertical" are used herein for convenience of description and refer to the orientation shown in the relevant drawing. For the avoidance of any doubt, this terminology is not intended to limit orientation in an external frame of reference.

Where used to describe a relationship between two components, "on" means "directly on". Where a first component is described as being "over" a second component, the first component may be on the second component, or there may be one or more further components arranged between the first and second components.

Provided herein are μLEDs which may have improved efficiency.

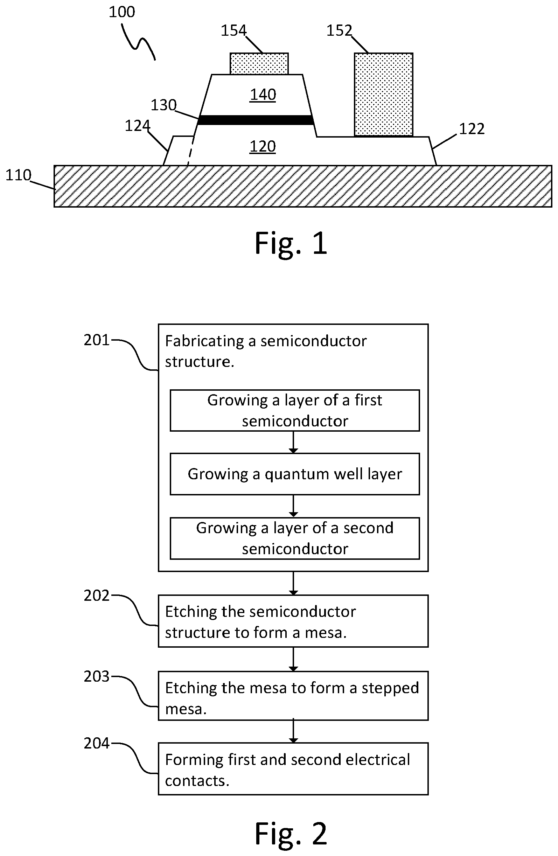

Fig. 1 is a schematic cross-section of a μLED device 100 according to a comparative example.

The μLED device 100 is includes a substrate 110. The substrate provides a support on which the μLED

is fabricated. The substrate typically comprises a wafer, i.e. a piece of single crystalline material. One example wafer material is sapphire ($\alpha$-Al$_2$O$_3$). Other examples of useful substrate materials include silicon and silicon carbide.

A light-emitting semiconductor structure is arranged epitaxially on the substrate 110. The light-emitting semiconductor structure comprises a layer of n-type semiconductor 120, a layer of p-type semiconductor 140, and a quantum well layer 130 therebetween.

In use, a voltage is applied across the layers of semiconductor 120, 140. Conductance band electrons are generated in the n-type semiconductor 120, and electron holes are generated in the p-type semiconductor 140. Recombination of the electrons and holes generates light. In this example, the recombination occurs in the quantum well layer 130.

The voltage is applied to the semiconductor layers 120, 140 via respective metal contacts 152, 154. To allow metal contact 152 to be connected to n-type semiconductor 120, the light-emitting semiconductor structure has a stepped profile. The quantum well 130 and the p-type semiconductor layer 140 only partially cover the n-type semiconductor layer 120. A region 122 of the n-type semiconductor layer 120 extends beyond the edge of p-type semiconductor layer 140 and the quantum well 130. Electrical contact 152 is connected to region 122.

The μLED 100 is fabricated as follows.

The n-type semiconductor layer 120, the quantum well 130, and the p-type semiconductor layer 140 are grown sequentially on the substrate 110. An island of n-type semiconductor 120 is formed by lithography. In the lithographic process, portions of the p-type semiconductor layer 140 and quantum well layer 130 are etched away to expose regions of the n-type semiconductor layer 120 around the perimeter of the island. This etch may be referred to as the "p-etch". The p-etch also reduces the thickness of the exposed regions of n-type semiconductor, but does not fully remove the n-type semiconductor from these regions.

After the p-etch, excess portions of the n-type semiconductor are selectively etched away in order to define the outer perimeter of the μLED. This etch is referred to as the "isolation etch".

The p-etch and the isolation etch form the stepped profile of the light-emitting semiconductor structure. Subsequently, the electrical contacts 152, 154 are added. An optional passivating layer of a dielectric material such as hafnium oxide, HfO, or aluminium oxide may be applied over the light-emitting semiconductor structure.

Lithographic processes have limited accuracy. Perfectly aligning two masks used to control two sequential etching steps is not possible. Consequently, the mask used in the isolation etch is configured such that all of the edges of the n-type semiconductor 120 extend beyond the edges of the quantum well 130 and p-type semiconductor 140. This prevents damage to the p-type semiconductor layer during the isolation etch. Edge extensions of layer 120 which are not used for the connection of an electrical contact are referred to as sidewall bumps 124.

The inventors have found that the presence of sidewall bumps is undesirable. Light is emitted from the sidewall bumps. This causes the source size to be larger than the size of the active region of the µLED. Light emission from the sidewall bump may cause unwanted optical interference. Light emission from the sidewall bump may constrain the "scale-out" of optical communication systems, by requiring µLEDs to be spaced further apart to reduce cross-talk between adjacent communication channels. "Scale-out" aims to provide a large number of simple, efficient, but relatively low-bandwidth communications channels, rather than aiming to increase the bandwidth per channel.

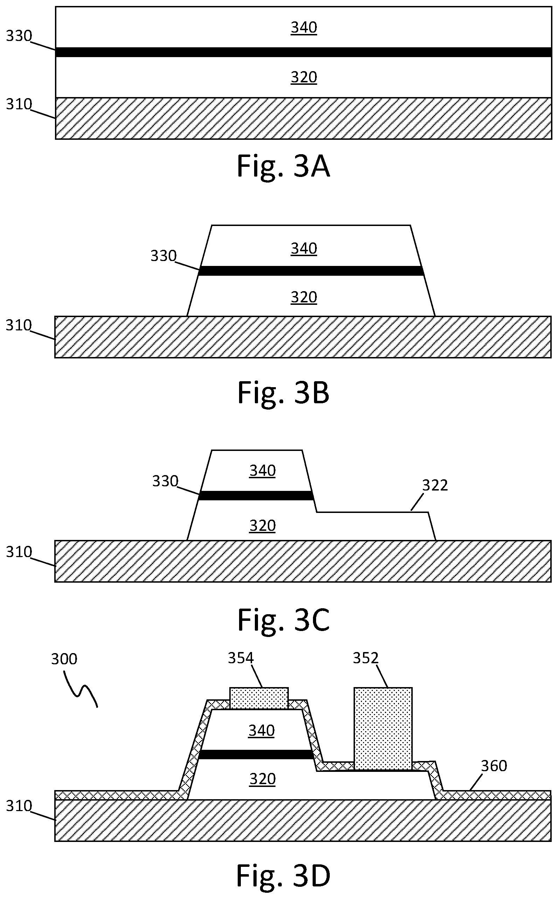

A method of fabricating a µLEDs which avoids the formation of sidewall bumps will now be explained with reference to Figs. 2 and 3. Fig. 2 is a flow diagram outlining the method. Figs. 3A to 3D are schematic cross-sections of workpieces obtained at various stages of the method.

The method commences at block 201, in which a semiconductor structure is fabricated. An example semiconductor structure is shown in Fig. 3A.

Fabricating the semiconductor structure comprises epitaxially growing a layer of a first semiconductor 320 on a substrate; growing a quantum well layer 330 on the layer of the first semiconductor; and growing a layer of a second semiconductor 340 on the quantum well layer 330 over the layer of the first semiconductor 320.

One of the first and second semiconductors is an n-type semiconductor, and the other of the first and second semiconductors is a p-type semiconductor. In the present example, layer 320 is a layer of n-type semiconductor and layer 340 is a layer of a p-type semiconductor.

The substrate 310 may be as described with reference to substrate 110 of Fig. 1. For example, the substrate may be a sapphire substrate, in particular a patterned sapphire substrate, PSS.

The natures of the n-type and p-type semiconductors are not particularly limited, provided that the finished device is capable of emitting light when a voltage is applied. Desirably, the n-type and p-type semiconductors and the material of the quantum well layer may be lattice-matched to allow the layers to be grown more easily. For example, the p-type semiconductor may be p-doped gallium nitride and the n-type semiconductor may be n-doped gallium nitride. Other examples of useful semiconductor materials include InGaN, AlGaN, GaAs, InGaAs, and AlGaAs.

The layers 320, 330, 340 are grown sequentially. Any suitable epitaxial growth technique or combination of such techniques may be used. One example technique is metal-organic chemical vapor deposition, MOCVD. MOCVD is particularly suitable for the epitaxial growth of gallium nitride layers.

Fig. 3A shows a single quantum well layer. In variants, two or more quantum well layers may be present. In other words, the light-emitting structure may include a multi-quantum well, MQW. In further variants, the quantum well layer may be omitted.

Subsequently, at block 202, the semiconductor structure is etched to form a mesa. An example mesa is shown in Fig. 3B.

A mesa is an island of semiconductor material. The etch defines the perimeter of the mesa by fully removing portions of the semiconductor layers surrounding the mesa. In this sense, the etch of block 202 is similar to the isolation etch described with reference to the comparative example of Fig. 1.

In implementations where multiple µLEDs are fabricated simultaneously on the same substrate, the etch 202 forms a plurality of mesas which are electrically isolated from one another. Each mesa forms the light-emitting semiconductor structure of a respective µLED.

Typically, the etch is controlled using a mask or stencil. The mask may be formed in situ by photolithography, electron beam lithography, or the like. Etching conditions may be selected as appropriate depending upon the nature of the semiconductor materials chosen.

After forming the mesa, the mesa is etched at block 203 to expose a portion 322 of the bottom semiconductor layer 320, which in this example is the n-type semiconductor layer. This operation produces a mesa having a stepped profile as illustrated in Fig. 3C.

Etch 203 selectively removes a portion of the p-type semiconductor 340 and the underlying quantum well layer 330 to expose a portion 322 of the n-type semiconductor 320. Provided that the n-type semiconductor is not fully removed, the etch may also attack the exposed portion 322 and reduce the thickness of the exposed portion 322.

The conditions used for the etch 203 may be the same as those used for a p-etch in the comparative process, as described above with reference to Fig. 1. The etch may be controlled using any appropriate mask or stencil.

Subsequently, at block 204, a first electrical contact 352 is formed on the exposed portion 322 of the n-type semiconductor 320; and a second electrical contact 354 is formed on top of the p-type semiconductor 340. The technique used to form the metal contact is not particularly limited and may be selected as appropriate. For example, a mask may be formed by photolithography, and metal contacts may be deposited in openings through the mask by evaporation.

A passivating layer 360 may also be applied over the semiconductor structure to protect the semiconductor materials from oxidation.

Fig. 3D illustrates an example µLED 300 obtainable by the method.

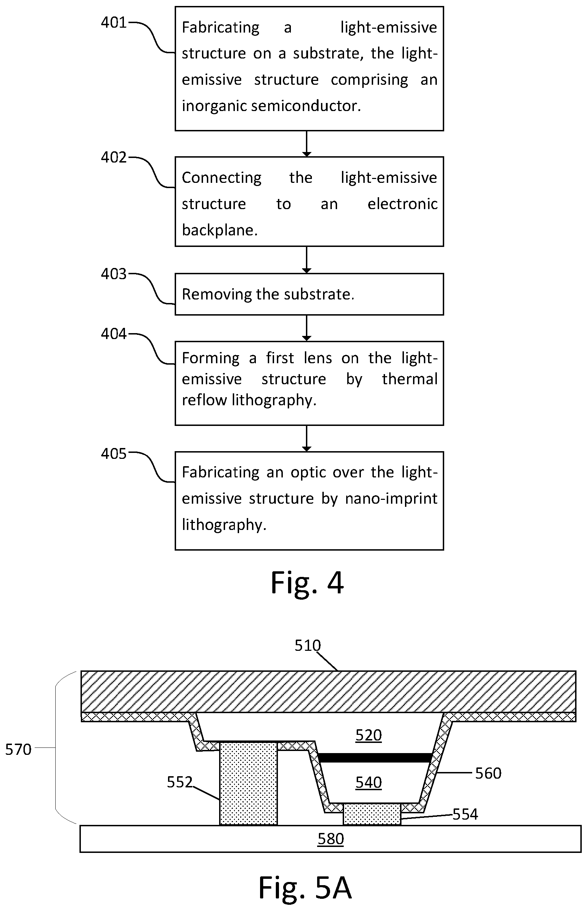

In implementations where the substrate 310 is transparent to light at the wavelength emitted by the semiconductor structure when in use, the method may terminate at block 204. Alternatively, the μLED 300 may be processed further, as will be described later with reference to Figs 4 and 5A to 5D.

As may be seen from Fig. 3D, the semiconductor structure is free of the sidewall bump 124 described with reference to Fig. 1. The sidewall bump is eliminated by performing the isolation etch before the p-etch. Since the μLED lacks a sidewall bump, the physical size of the μLED is reduced and undesirable light emission from the sides of the μLED is reduced. This may reduce optical interference and cross-talk when a plurality of such μLEDs is arranged in an array. The reduced size and reduced side-emission may allow reductions in the pitch of the array, in other words, for μLEDs to be arranged closer to one another. For example, adjacent ones of the μLEDs may be spaced apart by a pitch of less than 50 μm, optionally 10 to 50 μm.

Various modifications may be made to the example process.

For ease of explanation, the example describes the fabrication of a single μLED. Typically, a plurality of μLEDs is fabricated simultaneously on a single substrate.

The positions of the n-type and p-type semiconductors may be swapped.

Passivating layer 360 is optional and may be omitted. Quantum well layer 330 is optional and may be omitted in some implementations.

The semiconductor structure may include additional layers. For example, one or more buffer layers may be included. The buffer layer is a layer of crystalline material which is arranged between two layers having respective different lattice constants. The material of the buffer layer is selected to have lattice constant that is between the lattice constants of the two layers, to allow one material to be grown more easily atop the other.

A method of manufacturing a light-emitting diode device, including a light emitting diode, such as a μLED, and additional integrated optical component will now be described with reference to Figs 4 and 5A to 5D. Fig. 4 is a flow diagram outlining the method. Figs 5A to 5D are schematic cross-sections of workpieces obtained at various stages of the method.

At block 401, a light-emitting structure comprising an inorganic semiconductor is fabricated on a substrate.

In the present example, the light-emitting structure is fabricated in accordance with the method of Fig. 2. In a variant, the light emitting structure may be as described with reference to Fig. 1.

After fabricating the light-emitting structure, the light emitting structure is connected to an electronic backplane at block 402. This may comprise performing a "flip-chip" process. Flip-chip may also be referred to as controlled collapse chip connection or C4.

Fig. 5A shows a μLED 570 which has been connected to an electronic backplane 580. The μLED

570 is as previously described with reference to Fig. 3D. The μLED 570 has been turned upside down such that the substrate 510 is now at the top of the μLED. The electrical contacts 552, 554 of μLED 570 are connected to the electronic backplane 580 by solder joints or any other suitable electrical connection.

The electronic backplane 580 is depicted in a simplified form. The electronic backplane includes circuitry for applying an electrical potential to the light-emitting structure so as to cause the light-emitting structure to emit light.

Subsequently, at block 403, the substrate 510 is removed from the μLED 570. Removing the substrate may comprise performing laser lift-off debonding, LLO, for example. To allow for LLO, the substrate may comprise a material selected to be transparent to the wavelength of the laser used.

Alternative techniques may be used, for example etching; chemical-mechanical polishing; or substrate removal by the use of a sacrificial layer.

In the illustrated example, the substrate 510 is fully removed. Fully removing the substrate is not essential, particularly when the refractive index of the substrate is close to the refractive index of the semiconductor material. Therefore, in variants, the substrate may be only partially removed, i.e., thinned. In further variants, where the substrate is processable to form a micro-lens, the removal step may be omitted entirely.

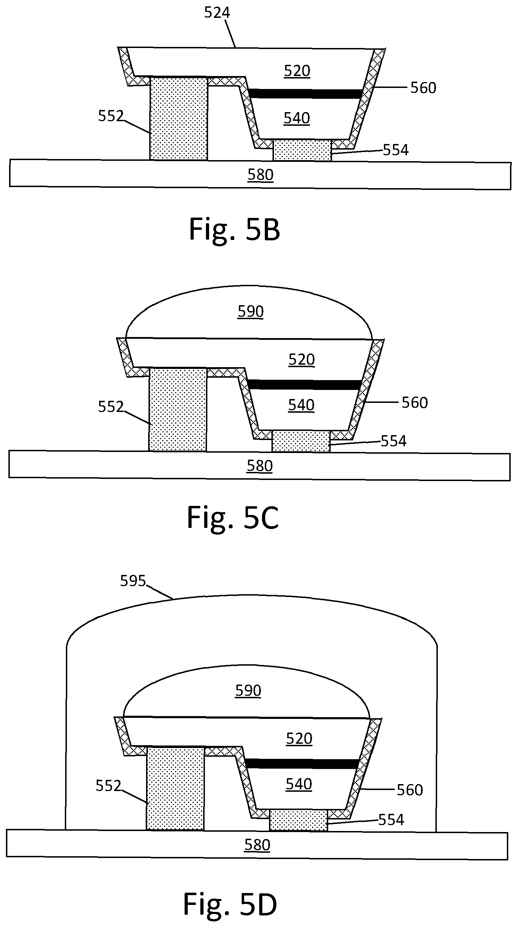

Fig. 5B illustrates the μLED 570 and electronic backplane 580 following the removal of the substrate 510. As may be seen, the bottom face 524 of the first semiconductor layer 520 becomes the top surface of the μLED 570.

In implementations in which the substrate 510 is a patterned substrate, the patterning of the substrate imparts a pattern into surface 524.

Alternatively, the semiconductor structure may be grown on a smooth substrate and surface 524 may be patterned or roughened after removing the substrate. Examples of patterning techniques include etching and plasma treatment. The patterning may optionally be controlled using an appropriate mask.

A "patterned" substrate has a surface which includes indentations or protrusions, such that the surface is not perfectly planar. The indentations or protrusions have depths which are greater than the wavelength of the light emitted by the light emitting diode, so as to avoid Rayleigh scattering. The indentations or protrusions may have depths less than or equal to 10 μm. For light emitting diodes that emit in the visible range, depths in the range 0.75 to 3 μm may be particularly suitable.

The pattern may be a regular, repeating pattern (for example, an array of cone-shaped protrusions) or an irregular pattern (for example, randomly-oriented scratches or defects).

Providing a patterned surface 524 may improve the efficiency of light extraction from the μLED, as will

now be discussed in detail.

Light which travels through a first medium and arrives at an interface with a second medium is refracted, as described by Snell's law:

$$n_1 sin\theta_1 = n_2 sin\theta_2$$

where:

$n_1$ is the refractive index of the first medium;
$\Theta_1$ is the angle of incidence of light on the interface;
$n_2$ is the refractive index of the material which the light enters; and
$\Theta_2$ is the angle of refraction.

The angles of incidence and angles of refraction are measured relative to the normal. The normal is a line at an angle of 90° to the interface.

The refractive index n of a medium is defined as:

$$n = \frac{c}{v}$$

where c is the speed of light in a vacuum, and v is the speed of light in the medium. The refractive index varies as a function of the wavelength of the light. Refractive indices are conventionally measured using a green spectral line of mercury having a wavelength of 546.07 nm.

If the first medium has a refractive index which is higher than that of the second medium, then for large angles of incidence the angle of refraction may be so large that the refracted ray is directed back into the first medium: in other words, reflected. This is referred to as total internal reflection.

Total internal reflection occurs when the angle of incidence exceeds a critical angle $\Theta_c$, which is defined as follows:

$$\theta_c = \arcsin\left(\frac{n_2}{n_1}\right)$$

Semiconductor materials typically have very high refractive indices. For example, GaN has a refractive index of approximately 2.4. The critical angle for light travelling out of GaN into air is therefore approximately 24.6°. Light which arrives at an interface at an angle of incidence that is less than the critical angle and is therefore able to exit the semiconductor is said to be "in the escape cone".

The normals at all points on a flat surface are parallel to one another.

Patterning or roughening the top surface 524 of the μLED 570 results in different parts of surface having differently-orientated normals. This creates multiple escape cones, thereby allowing a larger proportion of the light to be extracted from the μLED. Increased light extraction via the top surface 524 of the μLED 570 may also reduce undesirable light emission from the sides of the μLED 570.

Light travelling through a semiconductor material has a finite mean free path, and will eventually be absorbed by the material and converted to heat. Even if the semiconductor material itself has very low absorbance, defects and dopants can have significantly higher absorbance. Heat generation is undesirable. Excessive heat may, for example, shorten the useful lifespan of the μLED.

The efficiency of light extraction from the μLED may alternatively or additionally be improved by forming one or more optics over the μLED. To this end, the method of Fig. 4 further comprises, at block 404, forming a first lens 590 on the μLED by thermal reflow lithography.

The material of the first lens desirably has a refractive index which is as high as possible. Most desirably, the material may have a refractive index which is greater than or equal to the refractive index of the semiconductor material. For example, when the semiconductor material is GaN (n = 2.4), the material of the first lens may have a refractive index of greater than or equal to 2.4.

The material of the first lens typically has a refractive index which is higher than that of the material of the nanoimprinted lens. Thermal reflow lithography allows the shaping of certain materials that may not be compatible with nanoimprinting, but generally provides less control over shape. The use of the combination of a lens formed by thermal reflow lithography with a nanoimprinted optic may allow for improved efficiency of light extraction due to the high refractive index of the thermal reflow material, as well as effective collimation of the extracted light since fine control over the shape of the nanoimprinted optic is possible.

Thermal reflow lithography comprises depositing a layer of a photoresist onto a surface; selectively exposing and developing the photoresist to form one or more portion (e.g., cylinders) of cured photoresist on the surface; and then heating the cured photoresist to reflow the cured material and form a curved surface.

In implementations in which the substrate is not fully removed, the thermal reflow lithography may be performed on the substrate, over the light emitting diode structure. Forming the first lens may then further comprise, after reflowing the cured material, performing pattern transfer by etching the substrate (for example, by reactive ion etching). This process forms the first lens 590 from the material of the substrate. Semiconductor wafers useable as substrates may have high refractive indices. For example, InP has a refractive index of 3.6.

Where pattern transfer is used, the nature of the resist is not particularly limited. For example, the resist may be selected from poly(methyl methacrylate), poly(methoxy methylethyl acetate), poly(propylene glycol methyl ether acetate), and poly(methoxy-propyl acetate).

Alternatively, the thermal reflow lithography may form the first lens directly, without performing pattern transfer.

The material of the first lens is not particularly limited provided that the material is reflowable. It is desirable for the first lens to have a refractive index which is as high as possible, for example greater than or equal to 1.5, optionally greater than or equal to 1.8. The first lens may comprise a polymer, an inorganic material, or a composite material comprising a combination of a polymer and inorganic nanoparticles. Examples of useful polymers and composites have been described by Liu and Ueda (J. Mater. Chem. 2009, 19, 8907-8919, DOI: 10.1039/b909690f). High refractive index polymers and composites are commercially available.

The first lens 590 may be a spherical lens.

An example μLED including a first lens 590 is illustrated in Fig. 5C.

Providing the first lens 590 may improve the efficiency of the μLED. Since the material of the first lens 590 has a refractive index that is higher than that of air, the critical angle between the first lens 590 and the semiconductor 540 is larger. Consequently, a greater proportion of the generated light may be extracted from the semiconductor.

The method then proceeds to block 405, in which an optic is fabricated over the light-emitting diode structure by nano-imprint lithography. The optic may be configured to focus and/or collimate the emitted light.

In particular, photo nanoimprint lithography may be used. In photo nanoimprint lithography, a layer of resist is applied over the light-emitting diode structure, for example by spin-coating.

A mould is pressed into the resist to imprint a pattern into the resist. The resist is then cured (for example, by exposure to ultraviolet light), before separating the mould from the resist. The pattern is transferred onto the light-emitting diode structure by an appropriate pattern transfer process, typically reactive ion etching.

Other nano-imprint lithography techniques, such as thermoplastic nanoimprint lithography or resist-free direct nanoimprint lithography may be used as alternatives to photo nanoimprint lithography.

The optic typically comprises a material having a refractive index which is lower than that of the first lens 590. Since light emitted by the μLED passes through a series of materials having progressively lower refractive indices in a step-down manner, light extraction is made more efficient.

The nano-imprinted optic may comprise a polymer. The polymer may have a refractive index of greater than or equal to 1.3, optionally 1.5. For example, the polymer may have a refractive index in the range 1.5 to 1.9, optionally 1.5 to 1.8. Suitable polymers are commercially available, e.g. DELO PHOTOBOND VE 533861.

The nature of the optic is not particularly limited. The use of nanoimprint lithography allows a high degree of control over the form of the optic. For example, the optic may be configured to collimate or focus the emitted light.

Fig. 5D illustrates a μLED in which the optic is a spherical lens 595.

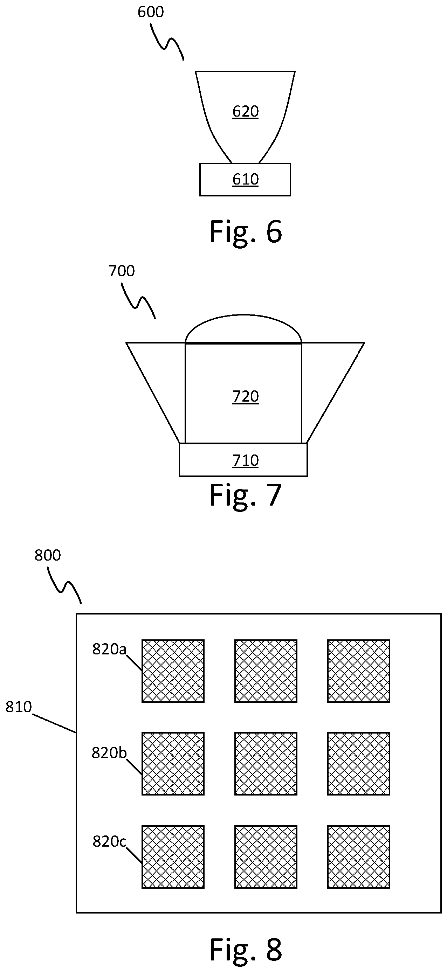

Alternatively, the optic may be a circular parabolic concentrator, CPC. An example light-emitting diode device including a light-emitting diode 610 and a circular parabolic concentrator 620 is illustrated in Fig. 6. A CPC efficiently collimates the emitted light. This may reduce cross-talk between channels when a plurality of such devices is arranged in an array.

In accordance with another possibility, the optic may be a total internal reflection, TIR, lens. A light-emitting diode device 700 including a light-emitting diode 710 and a total internal reflection lens 720 is illustrated in Fig. 7. A TIR lens efficiently collimates the emitted light. This may reduce cross-talk between channels when a plurality of such devices is arranged in an array.

The combination of the first lens 590 and the optic 595 may allow improved efficiency, as well as improved compatibility with optical fibres. Since the first lens may comprise a material with a high refractive index, the critical angle at the interface between the semiconductor and the first lens is high thereby allowing more radiant flux to be extracted: in other words, light can exit the semiconductor structure more easily, providing improved efficiency. The optic may then reduce the divergence of the light exiting the emitter. Shaping the light into a narrow cone reduces crosstalk between channels when multiple μLEDs are present, as well as reducing modal dispersion so as to allow more efficient transmission through the optical fibre.

Various modifications may be made to the described method and μLED.

The use of the flip-chip technique is optional. Any other appropriate technique may be used to connect the μLED to the backplane.

Removal of the substrate is optional. In some implementations, the method may terminate after block 402.

The use of a patterned substrate is optional, particularly in implementations where first lens 590 is present. Surface 524 may be a flat surface in some implementations.

The example μLED includes both a lens 590 formed by thermal reflow lithography and an optic formed by nano-imprint lithography 595. In variants, one of the lens 590 and the optic 595 may be omitted. A still further variant omits both the lens 590 and the optic 595.

In the drawing, the centre of lens 590 and the centre of optic 595 are illustrated as being aligned with the centre of the light-emitting structure. The centres of the lens 590 and optic 595 may be aligned with an active portion of the light emitting structure, for example a quantum well or multi-quantum well. In some implementations, the active region may be offset from the centre of the light-emitting structure.

A plurality of μLEDs as described herein may be arranged on a common backplane to form an array. A plan view of an example array 800 is shown in Fig. 8, showing the plurality of μLEDs 820a, 820b, 820c arranged on electronic backplane 810. The backplane includes circuitry for driving the μLEDs.

In the example, the μLEDs are arranged in a grid pattern, however as will be appreciated the arrangement of the μLEDs on the backplane is not particularly limited and may be selected as appropriate.

The distance between adjacent ones of the μLEDs in the array is referred to as the pitch. Since the μLEDs described herein emit less light from their sidewalls in comparison with conventional μLEDs, the pitch of the array may be reduced without introducing excessive interference or cross-talk.

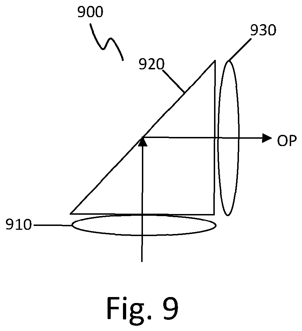

An example optical relay 900 which is useful in conjunction with the array 800 will now be described with reference to Fig. 9. Fig. 9 is a schematic cross-section of the optical relay.

The optical relay is useful for communicatively coupling the array 800 to a multi-core optical fibre.

The optical relay includes an input lens 910, a turning prism 920, and an output lens 930 arranged in series along an optical path OP.

The input lens 910 receives light from the array 800 and directs the light into the turning prism 920.

The turning prism 920 of this example is a 45° turning prism configured to redirect the output of the array 800 by an angle of 90°. This may allow for the more convenient integration of the array into computer systems. In a conventional computer system (such as a blade server or desktop PC), input and output sockets are orientated parallel to the computer system's circuit board.

The output lens 930 is arranged downstream of turning prism 920 along the optical path. In use, the output lens directs the light into an optical fibre, e.g. a multicore optical fibre.

The input lens and/or output lens may be configured to modify the numerical aperture and/or the diameter of the beam of light leaving the array to match more closely the requirements of the multi-core optical fibre. Alternatively or additionally, the input lens and/or output lens may magnify the output of the array to direct the light emitted from the μLEDs into the cores of the multi-core optical fibre.

Various modifications may be made to the optical relay. For example, Fig. 9 illustrates a single input lens and a single output lens. In variants, two or more input lenses or two or more output lenses may be present.

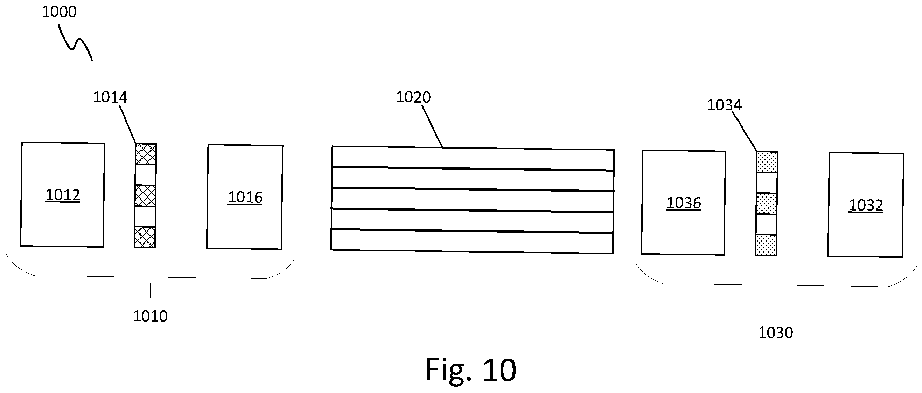

A block diagram of an example communication system including an array of μLEDs as defined herein is shown in Fig. 10.

System 1000 includes a transmitter 1010 and a receiver 1030. The transmitter 1010 and the receiver 1030 are communicatively coupled by an optical fibre 1020.

Transmitter 1010 comprises drive circuitry 1012, μLED array 1014, and transmit-side optical coupler 1016.

The drive circuitry may comprise an electronic backplane, such as backplane 810 as described previously with reference to Fig. 8.

The drive circuitry controls operation of the μLED array 1014. For example, the drive circuitry may switch individual μLEDs or groups of μLEDs on and off to transmit optically-encoded signal(s). The μLED array 1014 comprises a plurality of μLEDs as described herein.

The transmit side optical coupler 1016 may be an optical relay as described with reference to Fig. 9. The optical coupler directs light emitted by the μLED array 1014 into the optical fibre 1020.

The nature of the optical fibre 1020 is not particularly limited. The optical fibre may be a multi-core optical fibre, or a bundle of optical fibres. The optical fibre may be a multi-core polymer optical fibre. Polymer optical fibres may be easier to install than glass optical fibres because polymer fibres may be cut to length without special equipment and do not generate glass fragments when cut.

An example multi-core polymer optical fibre useful in the system 1000 is described in detail in WO 2023/191971 A1.

The receiver 1030 comprises a receive-side optical coupler 1036, a photodiode array 1034, and circuitry 1030.

The receive-side optical coupler 1036 may comprise an optical relay of the type described with reference to Fig. 9. The receive-side optical coupler 1036 receives light from the optical fibre 1020 and directs the light to the photodiode array 1034.

Photodiode array 1034 comprises a plurality of photodiodes arranged to receive light from respective ones of the cores of the optical fibre 1020. The photodiodes generate electrical signals in response to the received light.

Circuitry 1032 processes the electrical signals received from the photodiodes. For example, circuitry 1032 may convert analogue signals generated by the photodiodes into digital signals. Circuitry 1032 may decode the data transmitted from the receiver.

Since the μLED array 1014 includes a plurality of μLEDs, and the photodiode array comprises a plurality of photodiodes, the system may be configured to provide a plurality of spatially-multiplexed communication channels.

Each communication channel comprises a μLED in communication with a respective photodiode via a core of the optical fibre 1020.

The μLEDs and photodiodes may be over-provisioned. In other words, a single channel may include a plurality of μLEDs and a plurality of photodiodes. This may improve reliability of the system by providing redundant transmitters and receivers. Over-provisioning may also allow for faster installation of the communication system, since misalignment of the optical fibre with the transmitter and receiver can be more easily tolerated. Over-provisioning is described in detail in EP 4148474 A1.

The number of optical channels is not particularly limited. It is contemplated that a system may include hundreds or even thousands of independent optical channels. Compared to a conventional system using single-mode laser light sources, each channel is relatively low-cost. It is contemplated that systems having the architecture described herein could achieve aggregate throughputs of the order of terabits per second if a large number of channels are used.

Various modifications may be made to the described system.

In the example, a multi-core optical fibre is used. This may allow for convenient installation of the system by allowing the optical fibre to be aligned more easily with the transmitter and receiver. In a variant, a bundle of optical fibres may be used.

Optical fibres are flexible and are therefore convenient for use in many scenarios. In some implementations, a rigid waveguide may be used instead of an optical fibre.

Fig. 10 illustrates a uni-directional communication system. Bi-directional systems are also contemplated. In a bi-directional system, the transmitter and receiver are replaced with a pair of transceivers. A transceiver comprises both an array of μLEDs for transmitting signals, and an array of photodiodes for receiving signals.

Embodiments include μLED array devices that provide higher μLED densities and/or light extraction efficiencies, as compared with conventional device structures. High light extraction efficiencies can be achieved by patterning the light-emitting surfaces of the μLEDs and/or forming respective lenses on top of the light-emitting surfaces, to reduce losses caused by total internal reflection. High μLED densities are achieved by etching a mesa extending across all diode structure layers before etching the diode top layer(s) to create a stepped mesa, which avoids sidewall bumps, and/or by arranging an optic (e.g., a spherical lens, CPC, or TIR) configured to focus or collimate the emitted light on the diode structure; both features contribute to reduced cross-talk, allowing μLEDs to be spaced more closely.

It will be appreciated that the above embodiments have been described by way of example only.

More generally, according to one aspect disclosed herein, there is provided a method of manufacturing a light-emitting diode device. The method comprises: fabricating a light-emitting diode structure comprising an inorganic semiconductor; and fabricating an optic over the light-emitting diode structure by nano-imprint lithography.

Fabricating the light-emitting diode structure may comprise:

    epitaxially growing a layer of a first semiconductor over a substrate;
epitaxially growing a layer of a second semiconductor over the layer of the first semiconductor;
selectively etching the layers to form a mesa;
selectively etching the mesa to remove a portion of the second semiconductor along one edge of the mesa to form a stepped mesa having an exposed portion of the first semiconductor; and
forming a first electrical contact on the exposed portion of the first semiconductor, and forming a second electrical contact on the second semiconductor;
wherein one of the first and second semiconductors is a p-type semiconductor, and one of the first and second semiconductors is an n-type semiconductor.

The light-emitting diode structure may further include one quantum well, or multiple quantum wells, arranged between the layers of the first and second semiconductors.

Optionally, the first semiconductor is an n-type semiconductor, and the second semiconductor is a p-type semiconductor.

Fabricating the light-emitting diode structure may comprise fabricating the light-emitting diode structure on a substrate and subsequently removing the substrate. For example, the substrate may be removed by laser lift-off.

The method may further comprise patterning a surface of the light-emitting diode structure. In such implementations, the optic may be formed over the patterned surface.

The surface of the light-emitting diode may be patterned by growing the light-emitting diode structure on a substrate having a patterned surface. Alternatively, the surface of the light-emitting diode may be patterned by etching. The patterned surface may have surface features with depths in the range 0.75 to 3 μm.

In implementations which include a substrate, the substrate may be a sapphire substrate, optionally a natural sapphire substrate. Natural sapphire substrates have patterned surfaces.

The nature of the optic is not particularly limited. The optic may comprise a lens and/or an optical concentrator. For example, the optic may be a total internal reflection lens. In accordance with another possibility, the optic may be a circular parabolic concentrator.

The light-emitting structure may comprise any appropriate semiconductor material or combination of semiconductor materials. For example, the light emitting structure may comprise a semiconductor material selected from: GaN, InGaN, AlGaN, GaAs, InGaAs, AlGaAs, and InP. In particular, the light-emitting structure may comprise GaN.

The optic may comprise a material having a refractive index in the range 1.5 to 1.8.

The optic typically comprises a polymer material. High refractive index polymer materials (e.g., materials having a refractive index greater than or equal to 1.5) are commercially available.

The method may further comprise, after fabricating the light-emitting diode structure and before fabricating the optic, forming a first lens on the light-emitting diode structure using thermal reflow lithography.

The refractive index of the first lens is desirably as high as possible. In implementations which include both a first lens and a nano-imprinted optic, the first lens may comprise a material having a refractive index which is greater than that of the nano-imprinted optic. Especially desirably, the first lens may comprise a material having a refractive index greater than or equal to a refractive index of the light-emitting structure.

In some implementations, the light-emitting diode structure may be arranged on a substrate, and forming the first lens may comprise: performing thermal reflow lithography of a resist; and subsequently performing a pattern transfer from the resist to the substrate to form the first lens from the substrate.

In alternative implementations, the thermal reflow lithography forms the first lens directly. In other words, the first lens may comprise a resist material shaped by thermal reflow lithography.

The first lens may comprise an inorganic material, an organic polymer, or a composite material. For example, the first lens may comprise a composite material comprising a polymer material and inorganic nanoparticles.

The methods provided herein may in particular be used to fabricate micro light-emitting diode devices.

In implementations which include a lens obtained using thermal reflow lithography, the nano-imprinted optic may be omitted. Therefore, an alternative aspect provides a method of manufacturing a light-emitting diode device which includes fabricating a light-emitting diode structure comprising an inorganic semiconductor; and forming a first lens on the light-emitting diode structure using thermal reflow lithography. As will be appreciated, any of the various features described with reference to the first aspect may be implemented in the context of this alternative aspect.

The methods provided herein may be parallelised. In other words, the method may comprise fabricating a plurality of light-emitting diode structures; and fabricating a respective optic over each light-emitting diode structure.

Another aspect provides a light-emitting diode device, obtainable by the method of the first aspect. The light-emitting diode device comprises: a light-emitting structure comprising an inorganic semiconductor; and a nano-imprinted optic arranged over the light-emitting structure.

The light-emitting diode device may be a micro light-emitting diode device.

Optionally, exactly one side of the light-emitting structure has a stepped profile. The one side with the stepped profile allows attachment of an electrical contact.

Limiting the number of sides with stepped profiles may reduce light emission from the sides of the light-emitting structure. Such emission can contribute to optical interference and cross-talk in some use cases.

The light-emitting structure may have a patterned surface.

The optic may comprise a lens and/or an optical concentrator. For example, the optic may be a total internal reflection lens or a circular parabolic concentrator.

The light-emitting structure may comprise any suitable semiconductor material or combination of semiconductor materials. For example, the structure may comprise a semiconductor material selected from: GaN, InGaN, AlGaN, GaAs, InGaAs, and AlGaAs; optionally wherein the light-emitting structure comprises GaN.

The nano-imprinted optic may comprise a material having a refractive index in the range 1.5 to 1.8. The material may be a polymer material.

The light-emitting diode device may further comprise a lens obtainable by thermal reflow lithography arranged between the light emitting structure and the nanoimprinted optic. An alternative aspect provides a light-emitting diode device which includes the lens obtainable by thermal reflow lithography and omits the nano-imprinted lens.

The lens may comprise an inorganic material and/or a polymer material. The lens may comprises a composite material comprising a polymer material and inorganic nanoparticles.

Another aspect provides an array comprising a plurality of light-emitting diode devices as defined herein arranged on a backplane.

Particularly in implementations where exactly one side of each light-emitting structure has a stepped profile, the array may have a pitch of less than or equal to 50 $\mu$m, optionally in the range 10 to 50 $\mu$m. Providing a stepped profile on only a single side of the light-emitting structure may reduce the physical size of the light-emitting structure and/or may reduce light emission from the sides of the structure, thereby reducing optical inference between nearby LEDs of the array.

Another related aspect provides a system comprising an array as defined herein, and an optical relay arranged over the array. The optical relay may comprise a first lens, a turning prism arranged downstream of the first lens on an optical path, and a second lens arranged downstream of the turning prism on the optical path. The optical relay may be useful for optically coupling the array to a multi-core optical fibre.

Still another aspect provides a method of fabricating a light emitting diode device. The method comprises: epitaxially growing a layer of a first semiconductor over a substrate; epitaxially growing a layer of a second semiconductor over the layer of the first semiconductor; selectively etching the layers to form a mesa; selectively etching the mesa to remove a portion of the second semiconductor along one edge of the mesa, to form a stepped mesa having an exposed portion of the first semiconductor; and forming a first electrical contact on the exposed portion of the first semiconductor, and forming a second electrical contact on the second semiconductor. One of the first and second semiconductors is a p-type semiconductor, and one of the first and second semiconductors is an n-type semiconductor.

This method allows for the manufacture of a light-emitting diode device comprising: a first layer comprising a first inorganic semiconductor; a second layer comprising a second inorganic semiconductor, the second layer being arranged over the first layer; wherein exactly one edge of the first layer extends beyond an edge of the second layer, thereby defining an exposed portion of the first layer; wherein the light-emitting diode device further comprises a first electrical contact arranged on the exposed portion of the first layer, and a second electrical contact arranged on a top surface of the second layer; and wherein one of the first and second inorganic semiconductors is a p-type semiconductor and one of the first and second inorganic semiconductors is an n-type semiconductor.

In accordance with this aspect, only one edge of the first layer extends beyond an edge of the second layer. In other words, the light-emitting diode structure is free of side-wall bumps other than the side-wall bump which is used for connection of the first electrical contact. This may reduce the physical size of the LED and/or reduce light emission from the edges of the LED.

As will be appreciated, the LED of this aspect may include any of the features of the other LEDs provided here. For example, the LED may optionally include a lens obtainable by thermal reflow lithography and/or a nanoimprinted lens, as described with reference to the other aspects set out above.

The present disclosure provides the following Clauses:

Clause 1. A method of manufacturing a light-emitting diode device, which method comprises:

fabricating a light-emitting diode structure comprising an inorganic semiconductor; and
fabricating an optic over the light-emitting diode structure by nano-imprint lithography.

Clause 2. The method according to Clause 1, wherein fabricating the light-emitting diode structure comprises:

epitaxially growing a layer of a first semiconductor over a substrate;
epitaxially growing a layer of a second semiconductor over the layer of the first semiconductor;
selectively etching the layers to form a mesa;
selectively etching the mesa to remove a portion of the second semiconductor along one edge of the mesa to form a stepped mesa having an exposed portion of the first semiconductor; and forming a first electrical contact on the exposed portion of the first semiconductor, and forming a second electrical contact on the second semiconductor;
wherein one of the first and second semiconductors is a p-type semiconductor, and one of the first and second semiconductors is an n-type semiconductor;
optionally wherein the method further comprises forming one or more quantum wells between the layer of the first semiconductor and the layer of the second semiconductor.

Clause 3. The method according to Clause 2, wherein the first semiconductor is an n-type semiconductor, and the second semiconductor is a p-type semiconductor.

Clause 4. The method according to any Clause, wherein fabricating the light-emitting diode structure comprises fabricating the light-emitting diode structure on a substrate and subsequently removing the substrate.

Clause 5. The method according to Clause 4, wherein the substrate is removed by laser lift-off.

Clause 6. The method according to any preceding Clause, further comprising patterning a surface of the light-emitting diode structure;
wherein the optic is formed over the patterned surface.

Clause 7. The method according to Clause 6, wherein the surface is patterned by growing the light-emitting diode structure on a substrate having a patterned surface.

Clause 8. The method according to any of Clauses 2 to 7, wherein the substrate is a sapphire substrate, optionally a natural sapphire substrate.

Clause 9. The method according to any preceding Clause, wherein the optic comprises a lens and/or an optical concentrator.

Clause 10. The method according to Clause 9, wherein the optic is a total internal reflection lens.

Clause 11. The method according to Clause 9, wherein the optic is a circular parabolic concentrator.

Clause 12. The method according to any preceding Clause, wherein the light-emitting structure comprises a semiconductor material selected from: GaN, InGaN, AlGaN, GaAs, InGaAs, AlGaAs, and InP; optionally wherein the light-emitting structure comprises GaN.

Clause 13. The method according to any preceding Clause, wherein the optic comprises a polymer material.

Clause 14. The method according to any preceding Clause, wherein the optic comprises a material having a refractive index in the range 1.5 to 1.8.

Clause 15. The method according to any preceding claim, further comprising, after fabricating the light-emitting diode structure and before fabricating the optic:
forming a first lens on the light-emitting diode structure using thermal reflow lithography.

Clause 16. The method according to Clause 15, wherein the first lens comprises a material having a refractive index greater than or equal to a refractive index of the light-emitting structure.

Clause 17. The method according to Clause 15 or Clause 16, wherein the light-emitting diode structure is arranged on a substrate, and wherein forming the first lens comprises:

performing thermal reflow lithography of a resist; and
subsequently performing a pattern transfer from the resist to the substrate to form the first lens from the substrate.

Clause 18. The method according to Clause 15 or Clause 16, wherein the thermal reflow lithography forms the first lens directly.

Clause 19. The method according to Clause 18, wherein the first lens comprises an inorganic material and/or a polymer.

Clause 20. The method according to Clause 19, wherein the first lens comprises a composite material comprising a polymer material and inorganic nanoparticles.

Clause 21. The method according to any preceding Clause, wherein the light-emitting diode structure is a micro light-emitting diode structure.

Clause 22. The method according to any preceding Clause, comprising fabricating a plurality of light-emitting diode structures; and fabricating a respective optic over each light-emitting diode structure.

Clause 23. A light-emitting diode device, comprising:

a light-emitting structure comprising an inorganic semiconductor; and
a nano-imprinted optic arranged over the light-emitting structure.

Clause 24. The light-emitting diode device according to Clause 23, wherein exactly one side of the light-emitting structure has a stepped profile.

Clause 25. The light-emitting diode device according to Clause 23 or Clause 24, which is a micro light-emitting diode device.

Clause 26. The light-emitting diode device according to any of Clauses 23 to 25, wherein the light-emitting structure has a patterned surface.

Clause 27. The light-emitting diode device according to any of Clauses 23 to 26, wherein the optic comprises a lens and/or an optical concentrator.

Clause 28. The light-emitting diode device according to Clause 27, wherein the optic is a total internal reflection lens.

Clause 29. The light-emitting diode device according to Clause 27, wherein the optic is a circular parabolic concentrator.

Clause 30. The light-emitting diode device according to any of Clauses 23 to 29, wherein the light-emitting structure comprises a semiconductor material selected from: GaN, InGaN, AlGaN, GaAs, InGaAs, and AlGaAs; optionally wherein the light-emitting structure comprises GaN.

Clause 31. The light-emitting diode device according to any of Clauses 23 to 30, wherein the nano-imprinted optic comprises a material having a refractive index in the range 1.5 to 1.8.

Clause 32. The light-emitting diode device according to any of Clauses 23 to 31, wherein the nano-imprinted optic comprises a polymer material.

Clause 33. The light-emitting diode device according to any of Clauses 23 to 32, further comprising a lens obtainable by thermal reflow lithography arranged between the light emitting structure and the nanoimprinted optic.

Clause 34. The light-emitting diode device according to Clause 33, wherein the lens comprises a polymer and/or an inorganic material.

Clause 35. The light-emitting diode device according to Clause 34, wherein the lens comprises a composite material comprising a polymer material and inorganic nanoparticles.

Clause 36. An array comprising a plurality of light-emitting diode devices as defined in any of Clauses 23 to 34 or 51 to 56 arranged on a backplane.

Clause 37. The array according to Clause 36, having a pitch of less than or equal to 50 $\mu$m, optionally in the range 10 to 50 $\mu$m.

Clause 38. A system comprising:

an array as defined in Clauses 36 or Clause 37; and
an optical relay arranged over the array, the optical relay comprising a first lens, a turning prism arranged downstream of the first lens or an optical path, and a second lens arranged downstream of the turning prism on the optical path.

Clause 39. A method of fabricating a light emitting diode device, which method comprises:

epitaxially growing a layer of a first semiconductor over a substrate;
epitaxially growing a layer of a second semiconductor over the layer of the first semiconductor;
selectively etching the layers to form a mesa;
selectively etching the mesa to remove a portion of the second semiconductor along one edge of the mesa, to form a stepped mesa having an exposed portion of the first semiconductor; and
forming a first electrical contact on the exposed portion of the first semiconductor, and forming a second electrical contact on the second semiconductor;
wherein one of the first and second semiconductors is a p-type semiconductor, and one of the first and second semiconductors is an n-type semiconductor.

Clause 40. The method according to Clause 39, wherein the first semiconductor is an n-type semiconductor, and the second semiconductor is a p-type semiconductor.

Clause 41. The method according to Clause 39 or Clause 40, further comprising, after selectively etching the mesa and optionally after forming the first and second electrical contacts, removing the substrate.

Clause 41. The method according to Clause 41, wherein the substrate is removed by laser lift-off.

Clause 42. The method according to any of Clauses 39 to 41, further comprising patterning a surface of the light-emitting diode structure;

wherein the optic is formed over the patterned surface.

Clause 43. The method according to Clause 42, wherein the substrate has a patterned surface.

Clause 44. The method according to any of Clauses 39 to 43, wherein the substrate is a sapphire substrate, optionally a natural sapphire substrate.

Clause 45. The method according to any of Clauses 39 to 44, wherein the light-emitting structure comprises a semiconductor material selected from: GaN, InGaN, AlGaN, GaAs, InGaAs, AlGaAs, and InP; optionally wherein the light-emitting structure comprises GaN.

Clause 46. The method according to any of Clauses 39 to 45, wherein the light-emitting diode structure is a micro light-emitting diode structure.

Clause 47. The method according to any of Clauses 39 to 46, comprising fabricating a plurality of light-emitting diode structures.

Clause 48. The method according to any of Clauses 39 to 47; further comprising fabricating an optic over the light-emitting diode structure by nano-imprint lithography.

Clause 49. The method according to Clause 45, wherein the optic is as defined in any of Clauses 9 to 11, 13 and/or 14.

Clause 50. The method according to any of Clauses 39 to 49, further comprising forming a first lens on the light-emitting diode structure using thermal reflow lithography as defined in any of Clauses 15 to 20.

Clause 51. A light-emitting diode device comprising:

a first layer comprising a first inorganic semiconductor;
a second layer comprising a second inorganic semiconductor, the second layer being arranged over the first layer;
wherein exactly one edge of the first layer extends beyond an edge of the second layer, thereby defining an exposed portion of the first layer;
wherein the light-emitting diode device further comprises a first electrical contact arranged on the exposed portion of the first layer, and a second electrical contact arranged on a top surface of the second layer; and
wherein one of the first and second inorganic semiconductors is a p-type semiconductor and one of the first and second inorganic semiconductors is an n-type semiconductor.

Clause 52. The light-emitting diode device according to Clause 49, further comprising a nano-imprinted optic, optionally a nano-imprinted optic as defined in any of Clauses 26 to 29, 31, and/or 32.

Clause 53. The light-emitting diode device according to any of Clauses 50 to 51, further comprising a lens obtainable by thermal reflow lithography, optionally as defined in any of Clauses 33 to 35.

54. A light-emitting diode device, comprising:

a light-emitting structure comprising an inorganic semiconductor; and
a lens obtainable by thermal reflow lithography arranged over the light-emitting structure.

Clause 55. The light-emitting diode device according to Clause 54, further comprising a nano-imprinted optic, optionally a nano-imprinted optic as defined in any of Clauses 26 to 29, 31, and/or 32.

Clause 56. The light-emitting diode device according to Clause 54 or Clause 55, wherein the light-emitting structure is as defined in Clause 51.

Other variants or use cases of the disclosed techniques may become apparent to the person skilled in the art once given the disclosure herein. The scope of the disclosure is not limited by the described embodiments but only by the accompanying claims.

**Claims**

1. A method of manufacturing a light-emitting diode device, which method comprises:

fabricating a light-emitting diode structure (300) comprising an inorganic semiconductor; and
fabricating (405) an optic (595) over the light-emitting diode structure (300) by nano-imprint lithography.

2. The method according to claim 1, wherein fabricating the light-emitting diode structure (300) comprises:

epitaxially growing a layer of a first semiconductor (320) over a substrate (310);
epitaxially growing a layer of a second semiconductor (340) over the layer of the first semiconductor (320);
selectively etching (202) the layers to form a mesa;
selectively etching (203) the mesa to remove a portion of the second semiconductor (340) along one edge of the mesa to form a stepped mesa having an exposed portion (322) of the first semiconductor (320); and
forming (204) a first electrical contact (352) on the exposed portion (322) of the first semiconductor (320), and forming a second electrical contact (354) on the second semiconductor (340);
wherein one of the first and second semiconductors is a p-type semiconductor, and one of the first and second semiconductors is an n-type semiconductor.

3. The method according to claim 2, wherein the first semiconductor (320) is an n-type semiconductor, and the second semiconductor (340) is a p-type semiconductor.

4. The method according to any preceding claim, wherein fabricating the light-emitting diode structure (300) comprises fabricating (401) the light-emitting diode structure on a substrate (510) and subsequently removing (403) the substrate (510);
optionally wherein the substrate is removed by laser lift-off.

5. The method according to any preceding claim, further comprising patterning a surface (524) of the light-emitting diode structure (300);

wherein the optic (595) is formed over the patterned surface (524); and
optionally wherein the surface is patterned by growing the light-emitting diode structure (300) on a substrate having a patterned surface.

6. The method according to claim 1, wherein the optic (595) comprises a material having a refractive index in the range 1.5 to 1.8.

7. The method according to any preceding claim, further comprising, after fabricating the light-emitting diode structure (300) and before fabricating the optic (595):
forming a first lens (590) on the light-emitting diode structure (300) using thermal reflow lithography.

8. The method according to claim 7, wherein the light-emitting diode structure (300) is arranged on a substrate, and wherein forming the first lens (590) comprises:

performing thermal reflow lithography of a resist; and
subsequently performing a pattern transfer from the resist to the substrate to form the first lens (590) from the substrate.

9. The method according to claim 7, wherein the thermal reflow lithography forms the first lens (590) directly; optionally, wherein the first lens (590) comprises a composite material comprising a polymer material and inorganic nanoparticles.

10. A light-emitting diode device, comprising:

    a light-emitting structure (300) comprising an inorganic semiconductor; and
    a nano-imprinted optic (595) arranged over the light-emitting structure (300).

11. The light-emitting diode device according to claim 10, wherein exactly one side of the light-emitting structure has a stepped profile.

12. The light-emitting diode device according to claim 10 or claim 11, wherein the light-emitting structure has a patterned surface.

13. The light-emitting diode device according to any of claims 10 to 12, further comprising a lens obtainable by thermal reflow lithography arranged between the light emitting structure (300) and the nanoimprinted optic (595);
    optionally wherein the lens comprises a composite material comprising a polymer material and inorganic nanoparticles.

14. An array (800) comprising a plurality of light-emitting diode devices as defined in any of claims 10 to 13, arranged on a backplane (810), optionally wherein the array (800) has a pitch of less than or equal to 50 $\mu$m.

15. A system comprising:

    an array (800) as defined in claim 14; and
    an optical relay (900) arranged over the array (800), the optical relay (900) comprising a first lens (910), a turning prism (920) arranged downstream of the first lens (910) on an optical path, and a second lens (930) arranged downstream of the turning prism (920) on the optical path.

**Fig. 1**

**Fig. 2**

Fig. 3A

Fig. 3B

Fig. 3C

Fig. 3D

401 — Fabricating a light-emissive structure on a substrate, the light-emissive structure comprising an inorganic semiconductor.

402 — Connecting the light-emissive structure to an electronic backplane.

403 — Removing the substrate.

404 — Forming a first lens on the light-emissive structure by thermal reflow lithography.

405 — Fabricating an optic over the light-emissive structure by nano-imprint lithography.

## Fig. 4

510

570

520

552

540

560

554

580

## Fig. 5A

524

520

560

552

540

554

580

Fig. 5B

590

520

560

552

540

554

580

Fig. 5C

595

590

520

560

552

540

554

580

Fig. 5D

Fig. 6

Fig. 7

Fig. 8

Fig. 9

Fig. 10

**EP 4 648 109 A1**

<table>
<tr><td></td><td colspan="3">Europäisches<br>Patentamt<br>European<br>Patent Office<br>Office européen<br>des brevets</td><td colspan="2" style="text-align:center">**EUROPEAN SEARCH REPORT**</td><td>**Application Number**<br><br>EP 25 17 5529</td></tr>
</table>

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/199695 A1 (TAKIGUCHI MIKIO [JP] ET AL) 23 June 2022 (2022-06-23) | 1-6, 10-12, 14,15 | INV.<br>H01L25/075<br>H10H20/01 |
| Y | * paragraphs [0001] - [0187]; figures 1-11 * | 7-9,13 | H10H20/85<br>H10H20/855<br>H10H29/14 |
| | ----- | | |
| X | KUI BAO ET AL: "Improvement of light extraction from micro-pattern encapsulated GaN-based LED by imprinting", PROCEEDINGS OF SPIE, VISUAL COMMUNICATIONS AND IMAGE PROCESSING 2005, vol. 6910, 1 January 2008 (2008-01-01), pages 69100N-69100N-8, XP055004105, Visual Communications and Image Processing 2005, 2005, Beijing, China ISSN: 0277-786X, DOI: 10.1117/12.763285 | 1-3,6, 10,11, 14,15 | |
| A | * the whole document * | 4,5,7-9, 12,13 | |
| | ----- | | |
| Y | US 2022/229209 A1 (GUO KANG [CN] ET AL) 21 July 2022 (2022-07-21) * the whole document * | 7-9,13 | **TECHNICAL FIELDS SEARCHED (IPC)**<br><br>H01L<br>H10H |
| | ----- | | |

The present search report has been drawn up for all claims

| Place of search | Date of completion of the search | Examiner |
|---|---|---|
| The Hague | 6 September 2025 | Saynova, Desislava |

## ANNEX TO THE EUROPEAN SEARCH REPORT
## ON EUROPEAN PATENT APPLICATION NO.

EP 25 17 5529

This annex lists the patent family members relating to the patent documents cited in the above-mentioned European search report.
The members are as contained in the European Patent Office EDP file on
The European Patent Office is in no way liable for these particulars which are merely given for the purpose of information.

06-09-2025

| Patent document cited in search report | Publication date | Patent family member(s) | Publication date |
|---|---|---|---|
| US 2022199695 A1 | 23-06-2022 | JP WO2020209109 A1 | 15-10-2020 |
| | | US 2022199695 A1 | 23-06-2022 |
| | | WO 2020209109 A1 | 15-10-2020 |
| US 2022229209 A1 | 21-07-2022 | CN 114815299 A | 29-07-2022 |
| | | US 2022229209 A1 | 21-07-2022 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2023191971 A1

- EP 4148474 A1

**Non-patent literature cited in the description**

- **LIU ; UEDA**. *J. Mater. Chem.*, 2009, vol. 19, 8907-8919